# EUROPEAN PATENT APPLICATION

(11) **EP 2 437 583 A1**
(43) Date of publication of application: **04.04.2012**
(21) Application number: 09845169.3
(22) Date of filing: 25.05.2009
(51) Int. Cl.: H05K 7/20

(54) **ELECTRONIC DEVICE AND COOLING FAN CONTROL METHOD**

(71) Applicant: NEC Display Solutions, Ltd., Minato-ku Tokyo 108-0023 (JP)
(72) Inventor: NAITOU, Michitaka, Tokyo 108-0023 (JP); MASUDA, Naoki, Tokyo 108-0023 (JP)
(74) Representative: Günther, René
(86) International application number: PCT/JP2009/059519
(87) International publication number: WO 2010/137102

(57) **Abstract**

An electronic device capable of reducing a continuously generated whining sound is provided. Electronic device (1) includes: cooling target (2); cooling fan (3) that cools cooling target (2); temperature detector (4) that detects the temperature of cooling target (2); and controller (5) that determines a driving voltage to be supplied to cooling fan (3) on the basis of the temperature of cooling target (2) detected by temperature detector (4), supplies the driving voltage to cooling fan (3), and, when a waiting time for updating the driving voltage has elapsed after supplying the driving voltage, redetermines the driving voltage on the basis of the temperature of cooling target (2) detected by temperature detector (4) at that point in time and supplies the driving voltage to cooling fan.

## Description

### Technical Field

The present invention relates to an electronic device and a cooling fan control method.

### Background Art

An electronic devices that prevents an increase in the temperature in a device through the use of a cooling fan has been known.

Patent Literature 1 describes a control device that controls the number of revolutions of a cooling fan provided in the electronic device per unit time (hereinafter, simply referred to as "the number of revolutions").

Once the control device measures the temperature of the electronic device, the control device defines a target voltage on the basis of the measured temperature and changes a voltage to be supplied to the cooling fan (hereinafter, referred to as "supply voltage") to the target voltage, thereby adjusting the number of revolutions of the cooling fan.

Once the control device changes the supply voltage to the target voltage, the control device immediately remeasures the temperature of the electronic device, defines a new target voltage on the basis of the remeasured temperature and changes the supply voltage to the new target voltage.

### Citation List

### Patent Literature

Patent Literature 1: JP2001-56724A

### Summary of Invention

### Technical Problem

After the control device described in Patent Literature 1 changes the supply voltage to the target voltage, the control device immediately remeasures the temperature of the electronic device, defines the new target voltage on the basis of the remeasured temperature and changes the supply voltage to the new target voltage. Accordingly, for instance, in a situation where the temperature of the electronic device fluctuates, an update interval of the supply voltage shortens.

If the update interval of the supply voltage shortens, the number of revolutions of the cooling fan may uninterruptedly vary.

The variation in the number of revolutions of the cooling fan in turn varies the frequency characteristics of sound with rotation of the cooling fan. The variation in sound frequency characteristics causes a sound that is offensive to the ears of a user (hereinafter, referred to as "whining sound").

Accordingly, a problem with the control device described in Patent Literature 1 is that, for instance, since the update interval of the supply voltage shortens in a situation where the temperature of the electronic device fluctuates, a whining sound tends to occur continuously.

It is an object of the present invention to provide an electronic device and a cooling fan control method that can solve these problems.

### Solution to Problem

An electronic device of the present invention includes: a cooling target; a cooling fan that cools the cooling target; temperature detection means that detects a temperature of the cooling target; and control means that determines a driving voltage to be supplied to the cooling fan on the basis of the temperature of the cooling target detected by the temperature detection means, supplies the driving voltage to the cooling fan, and, when a waiting time for updating the driving voltage has elapsed after supplying the driving voltage, redetermines the driving voltage on the basis of the temperature of the cooling target detected by the temperature detection means at that point in time and supplies the driving voltage to the cooling fan.

A cooling fan control method of the present invention is a cooling fan control method in an electronic device, the method including: detecting a temperature of a cooling target; and determining a driving voltage to be supplied to a cooling fan on the basis of the temperature of the cooling target, supplying the driving voltage to the cooling fan, and, when a waiting time for updating the driving voltage has elapsed after supplying the driving voltage, redetermining the driving voltage on the basis of the temperature of the cooling target detected at that point in time and supplying the driving voltage to the cooling fan.

### Advantageous Effects of Invention

The present invention can reduce the continuously generated whining sound.

### Brief Description of Drawings

[Figure 1] Figure 1 is a block diagram showing electronic device 1 of an exemplary embodiment of the present invention.
[Figure 2] Figure 2 is a diagram showing an example of details represented by information registered in table 7a.
[Figure 3] Figure 3 is a diagram showing an example of details represented by information registered in table 7b.
[Figure 4] Figure 4 is a flowchart for illustrating an operation of electronic device 1.

### Description of Embodiment

An exemplary embodiment of the present invention will hereinafter be described with reference to drawings.

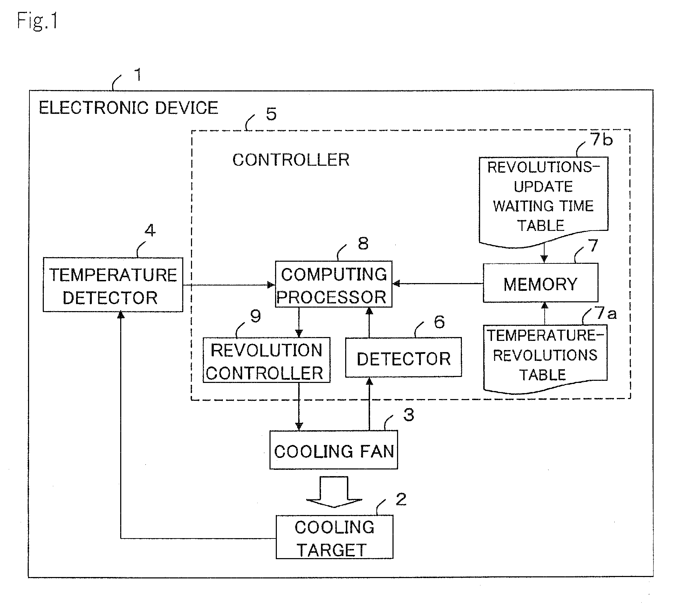

Figure 1 is a block diagram showing electronic device 1 of the exemplary embodiment of the present invention.

In Figure 1, electronic device 1 includes cooling target 2, cooling fan 3, temperature detector 4 and controller 5. Controller 5 includes detector 6, memory 7, computing processor 8 and revolution controller 9.

Electronic device 1 is, for instance, a projector or a personal computer. Electronic device 1 is not limited to a projector or a personal computer, and can appropriately be changed.

Cooling target 2 is a heat generating device and is cooled by cooling fan 3. In a case where electronic device 1 is a projector, for instance, the projector uses a projection lamp as cooling target 2. In a case where electronic device 1 is a personal computer, for instance, the personal computer uses a CPU (Central Processing Unit) as cooling target 2. Cooling target 2 is not limited to a projection lamp or a CPU, and can appropriately be changed.

Cooling fan 3 is used for cooling cooling target 2. The number of revolutions (the number of revolutions per unit time) of cooling fan 3 varies according to the supplied driving voltages. In this exemplary embodiment, the number of revolutions of cooling fan 3 increases with the supplied driving voltage.

Temperature detector 4 can generally be referred to as temperature detection means. Temperature detector 4 detects the temperature of cooling target 2. Temperature detector 4 may directly detect the temperature of cooling target 2, or may detect an ambient temperature of cooling target 2 and indirectly detect the temperature of cooling target 2 from the ambient temperature. Temperature detector 4 outputs temperature information representing the temperature of cooling target 2 to controller 5 (more specifically, computing processor 8).

Controller 5 can generally be referred to as control means.

Controller 5 determines a driving voltage to be supplied to cooling fan 3 on the basis of the temperature of cooling target 2 detected by temperature detector 4, and supplies the driving voltage to cooling fan 3. For instance, controller 5 increases the driving voltage with the temperature of cooling target 2.

In this exemplary embodiment, controller 5 determines the target number of revolutions of cooling fan 3 on the basis of the temperature of cooling target 2 and in turn determines the driving voltage on the basis of the target number of revolutions. For instance, controller 5 increases the target number of revolutions with the temperature of cooling target 2. For instance, controller 5 increases the driving voltage with the target number of revolutions.

When a waiting time for updating the driving voltage (hereinafter, simply referred to as "waiting time") has elapsed, since controller 5 supplied the driving voltage to cooling fan 3, controller 5 redetermines the driving voltage on the basis of the temperature of cooling target 2 detected by temperature detector 4 at that point in time and supplies the redetermined driving voltage to cooling fan 3.

The waiting time may be determined, for instance, by controller 5 on the basis of the temperature of cooling target 2 or may be a constant value.

In this exemplary embodiment, controller 5 determines the target number of revolutions of cooling fan 3 on the basis of the temperature of cooling target 2 and in turn determines the waiting time on the basis of the target number of revolutions. For instance, the more a whining sound is apt to occur owing to the number of revolutions being changed to the target number of revolutions, the longer is the waiting time to be determined on the basis of this target number of revolutions controller 5.

Detector 6 detects the number of revolutions of cooling fan 3. Detector 6 outputs information of the number of revolutions representing the number of revolutions of cooling fan 3 to computing processor 8.

Memory 7 stores temperature-revolutions table (hereinafter, simply referred to as "table") 7a and revolutions-update waiting time table (hereinafter, simply referred to as "table") 7b.

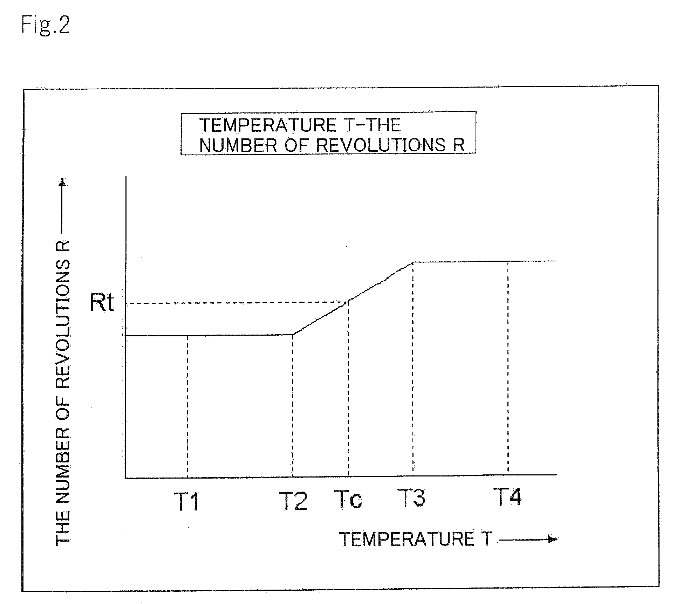

Table 7a has registered therein information of the target number of revolutions that represents the target numbers of revolutions associated with the respective temperatures of cooling target 2. Figure 2 is a diagram showing an example of details represented by information registered in table 7a.

Table 7b has registered therein waiting time information representing waiting times associated with the respective target numbers of revolutions of cooling fan 3. In this exemplary embodiment, the more a whining sound is apt to occur owing to the number of revolutions being changed to the target number of revolutions, the longer is the waiting time associated with this target number of revolutions.

In this exemplary embodiment, a range of the number of revolutions in which cooling fan 3 is operable is divided into a first revolution range and a second revolution range.

In a case where the number of revolutions of cooling fan 3 is changed to the target number of revolutions in the first revolution range, the whining sound is more apt to occur than a case where the number of revolutions of cooling fan 3 is changed to the target number of revolutions in the second revolution range.

In other words, in the case where the number of revolutions of cooling fan 3 is changed to the target number of revolutions in the first revolution range, the whining sound generated by the change of the number of revolutions of cooling fan 3 is more apt to be recognized by people than in the case where the number of revolutions of cooling fan 3 is changed to the target number of revolutions in the second revolution range.

In table 7b, waiting times associated with the respective target numbers of revolutions in the first revolution range are longer than waiting times associated with the respective target numbers of revolutions in the second revolution range.

In this exemplary embodiment, the range of the number of revolutions in which cooling fan 3 is operable is divided into the first and second revolution ranges. However, the range of the number of revolutions in which cooling fan 3 is operable may be divided into at least three ranges. In this case, it is preferable that waiting times associated with the respective ranges be appropriately set according to a level where the whining sound is apt to be recognized due to change of the number of revolutions to the target number of revolutions in the range concerned.

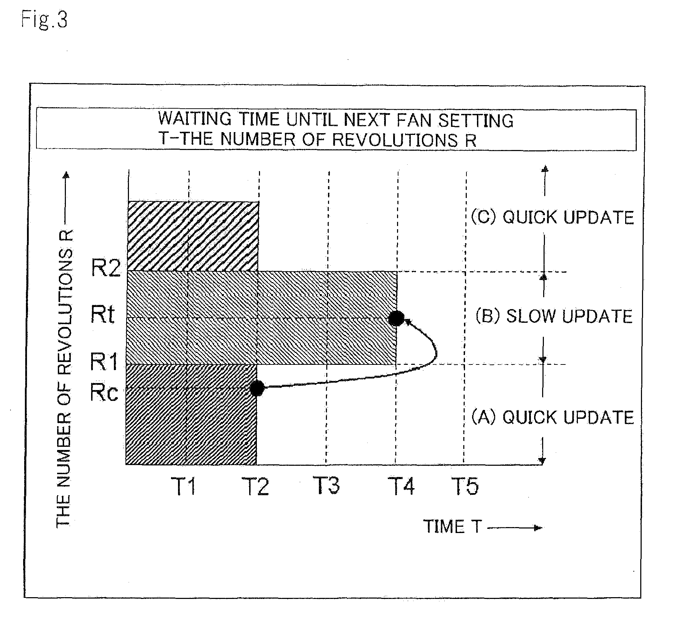

Figure 3 is a diagram showing an example of details represented by information registered in table 7b.

In Figure 3, a range of the number of revolutions that is at least the number of revolutions R1 and not more than the number of revolutions R2 is used as the first revolution range. A range of the number of revolutions less than the number of revolutions R1 and a range of the number of revolutions more than the number of revolutions R2 are used as the second revolution range. Note that R1 < R2. It is preferable that R1 and R2 be appropriately selected according to characteristics of cooling fan 3 (e.g. the shape of cooling fan 3).

The waiting time information representing the waiting time associated with the number of revolutions in the first revolution range represents time T4. The waiting time information representing the waiting time associated with the number of revolutions in the second revolution range represents time T2. Note that T2 < T4. It is preferable that T2 and T4 be appropriately set according to characteristics of cooling fan 3 (e.g. the shape and weight of cooling fan 3).

Computing processor 8 includes a timer and controls cooling fan 3.

When computing processor 8 accepts the temperature information from temperature detector 4, computing processor 8 reads information of the target number of revolutions corresponding to the temperature represented by the temperature information from memory 7 (table 7a).

When the target number of revolutions represented by the information of the target number of revolutions is different from the actual number of revolutions of cooling fan 3 represented by the information of the number of revolutions from detector 6, computing processor 8 outputs the information of the target number of revolutions to revolution controller 9.

When revolution controller 9 accepts the information of the target number of revolutions from computing processor 8, revolution controller 9 generates the driving voltage on the basis of the information of the target number of revolutions. For instance, revolution controller 9 increases the driving voltage with the target number of revolutions represented by the information of the target number of revolutions.

Revolution controller 9 holds driving voltage information representing driving voltages corresponding to respective target numbers of revolutions, reads the driving voltage information corresponding to the target number of revolutions represented by the information of the target number of revolutions, and generates the driving voltage represented by the driving voltage information.

Revolution controller 9 holds an operational formula for calculating the driving voltage using the target number of revolutions and may calculate the driving voltage using the target number of revolutions represented by the information of the target number of revolutions and the operational formula, thus generating the calculated driving voltage.

When revolution controller 9 generates the driving voltage, revolution controller 9 supplies the driving voltage to cooling fan 3, thereby adjusting the number of revolutions of cooling fan 3. When revolution controller 9 supplies the driving voltage to cooling fan 3, revolution controller 9 outputs supply completion information representing that the supply has been completed, to computing processor 8.

When computing processor 8 accepts the supply completion information from revolution controller 9, computing processor 8 performs a control operation, which will be described below.

In the control operation, computing processor 8 reads from memory 7 the waiting time information corresponding to the target number of revolutions represented by the information of the target number of revolutions and then waits until the waiting time represented by the waiting time information read from memory 7 has elapsed. After the waiting time has elapsed, computing processor 8 reaccepts the temperature information from temperature detector 4 and also reaccepts the information of the number of revolutions from detector 5. Computing processor 8 reads from memory 7 the information of the target number of revolutions corresponding to the temperature represented by the temperature information from the temperature detector 4. When the target number of revolutions represented by the information of the target number of revolutions is different from the actual number of revolutions of cooling fan 3 represented by the information of the number of revolutions, computing processor 8 outputs the information of the target number of revolutions to revolution controller 9.

Subsequently, computing processor 8 performs the control operation every time when receiving the supply completion information from revolution controller 9.

Computing processor 8 determines whether or not the waiting time has elapsed or not using the timer in computing processor 8.

Computing processor 8 may perform the control operation every time when outputting the information of the target number of revolutions to revolution controller 9, instead of performing the control operation every time when receiving the supply completion information from revolution controller 9.

Next, an operation will be described.

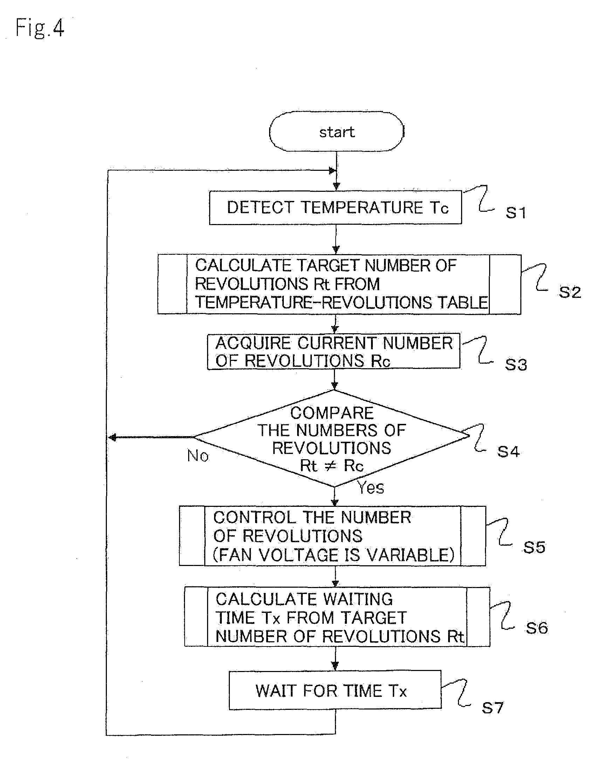

Figure 4 is a flowchart for illustrating an operation of electronic device 1.

In step S1, computing processor 8 accepts the temperature information representing the temperature (Tc) of cooling target 2 for calculating the target number of revolutions, from temperature detector 4. After computing processor 8 accepts the temperature information, computing processor 8 executes step S2.

In step S2, computing processor 8 acquires from memory 7 the information of the target number of revolutions representing the target number of revolutions (Rt) corresponding to the temperature (Tc) represented by the temperature information (see Figure 2). After computing processor 8 accepts the information of the target number of revolutions, computing processor 8 executes step S3.

In step S3, computing processor 8 accepts from detector 6 the information of the number of revolutions representing the current number of revolutions of cooling fan 3 (Rc). After computing processor 8 accepts the information of the number of revolutions, computing processor 8 executes step S4.

In step S4, computing processor 8 compares the target number of revolutions (Rt) represented by the information of the target number of revolutions with the actual number of revolutions (Rc) represented by the information of the number of revolutions. If the target number of revolutions (Rt) is equal to the actual number of revolutions (Rc), computing processor 8 returns the processing to step S1. On the other hand, if the target number of revolutions (Rt) is not equal to the actual number of revolutions (Rc), computing processor 8 executes step S5.

In step S5, computing processor 8 outputs the information of the target number of revolutions to revolution controller 9. When revolution controller 9 accepts the information of the target number of revolutions, revolution controller 9 generates the driving voltage on the basis of information of the target number of revolutions. Revolution controller 9 supplies the driving voltage to cooling fan 3, thereby adjusting the number of revolutions of cooling fan 3. When revolution controller 9 supplies the driving voltage to cooling fan 3, revolution controller 9 outputs the supply completion information to computing processor 8. When computing processor 8 accepts the supply completion information, computing processor 8 executes step S6.

In step S6, computing processor 8 reads from memory 7 the waiting time information representing waiting time (Tx) corresponding to the target number of revolutions (Rt) represented by the information of the target number of revolutions (see Figure 3). According to Figure 3, in a case where Rt is less than R1 or Rt is higher than R2, waiting time (Tx) becomes time T2; in a case where Rc is at least R1 and not more than R2, waiting time (Tx) becomes time T4. After computing processor 8 reads the waiting time information, computing processor 8 executes step S7.

In step S7, computing processor 8 waits until waiting time (Tx) represented by the waiting time information has elapsed. After waiting time (Tx) elapsed, computing processor 8 returns the processing to step S 1.

According to this exemplary embodiment, when the waiting time for updating the driving voltage has elapsed, since controller 5 supplied the driving voltage to cooling fan 3, controller 5 redetermines the driving voltage on the basis of the temperature of cooling target 2 detected by the temperature detector 4 at that point in time and supplies the redetermined driving voltage to cooling fan 3.

Accordingly, the time interval for updating the voltage to be supplied to cooling fan 3 can be increased in comparison with a case where, immediately after the supply of the driving voltage has been completed, the driving voltage is redetermined on the basis of the temperature of cooling target 2 detected by temperature detector 4 and the redetermined driving voltage is supplied to cooling fan 3.

Therefore, for instance, the frequency of variation in the number of revolutions of cooling fan 3 can be reduced in a situation where the temperature of cooling target 2 varies. This enables the continuously generated whining sound to be reduced.

In this exemplary embodiment, controller 5 determines the waiting time for updating the driving voltage on the basis of the temperature of cooling target 2 detected by temperature detector 4. The driving voltage is also determined on the basis of the temperature of cooling target 2. This allows the waiting time for updating the driving voltage to be variable according to the temperature of cooling target 2, that is, the driving voltage.

In a case where controller 5 determines the target number of revolutions of cooling fan 3 on the basis of the temperature of cooling target 2 and determines the waiting time for updating the driving voltage on the basis of the target number of revolutions, the more the whining sound is apt to occur owing to the number of revolutions being changed to the target number of revolutions, the longer is the waiting time for updating the driving voltage determined by controller 5 preferably on the basis of the target number of revolution.

In this case, under a situation where the frequency of generating the whining sound is reduced and the probability of generating the whining sound is low, the number of revolutions of cooling fan 3 can immediately be changed. This allows an increase in temperature of the electronic device 1 and generation of the whining sound to be suppressed in a balanced manner.

In this exemplary embodiment, the waiting time representing a time of waiting until the supply voltage to cooling fan 3 at the next time is set, and these waiting times are set for the respective target numbers of revolutions according to the level where the whining sound is apt to be recognized.

This allows the variation speed of the number of revolutions of the fan to be gentle for the revolution range in which the whining sound is apt to be recognized, thereby enabling the auditory grating whining sound to be reduced.

In the exemplary embodiment, controller 5 determines the target number of revolutions of cooling fan 2 using table 7a in memory 7 on the basis of the temperature of cooling target 2 detected by temperature detector 4. However, controller 5 may hold an operational formula for calculating the target number of revolutions using the temperature of cooling target 2, and determine the target number of revolutions using the temperature of cooling target 2 detected by temperature detector 4 and the operational formula.

In the exemplary embodiment, controller 5 determines the waiting time using table 7b in memory 7 on the basis of the target number of revolutions. However, controller 5 may hold an operational formula for calculating the waiting time using the target number of revolutions, and determine the waiting time using the target number of revolutions and the operational formula.

Although the present invention has been described above with reference to the exemplary embodiment, the present invention is not limited to the exemplary embodiment. Various modifications that a person skilled in the art can understand may be made to the configuration and details of the present invention within the scope of the invention of the application.

### Reference Signs List

- 1: electronic device
- 2: cooling target
- 3: cooling fan
- 4: temperature detector
- 5: controller
- 6: detector
- 7: memory
- 8: computing processor
- 9: revolution controller

## Claims

1. An electronic device, comprising:
a cooling target;
a cooling fan for cooling said cooling target;
temperature detection means for detecting a temperature of said cooling target; and
control means for determining a driving voltage to be supplied to said cooling fan on the basis of the temperature of said cooling target detected by said temperature detection means, supplying the driving voltage to said cooling fan, and, when a waiting time for updating the driving voltage has elapsed after supplying the driving voltage, redetermining the driving voltage on the basis of the temperature of said cooling target detected by said temperature detection means at that point in time and supplying the driving voltage to said cooling fan.

2. The electronic device according to claim 1, wherein said control means further determines the waiting time for updating the driving voltage on the basis of the temperature of said cooling target detected by said temperature detection means.

3. The electronic device according to claim 2, wherein said control means determines a target number of revolutions of said cooling fan on the basis of the temperature of said cooling target detected by said temperature detection means, and further determines the waiting time for updating the driving voltage on the basis of the target number of revolutions, and wherein the more a whining sound is apt to occur owing to the number of revolutions being changed to the target number of revolutions, the longer is the waiting time for updating the driving voltage that is determined on the basis of the target number of revolutions.

4. A cooling fan control method in an electronic device, the method comprising:
detecting a temperature of a cooling target; and
determining a driving voltage to be supplied to a cooling fan on the basis of the temperature of said cooling target, supplying the driving voltage to said cooling fan, and, when a waiting time for updating the driving voltage has elapsed after supplying the driving voltage, redetermining the driving voltage on the basis of the temperature of said cooling target detected at that point in time and supplying the driving voltage to said cooling fan.

5. The cooling fan control method according to claim 4, the method further comprising determining the waiting time for updating the driving voltage on the basis of the temperature of said cooling target.

6. The cooling fan control method according to claim 5, the method further comprising:
determining a target number of revolutions of said cooling fan on the basis of the temperature of said cooling target,
determining the waiting time for updating the driving voltage on the basis of the target number of revolutions, and
wherein the more a whining sound is apt to occur owing to the number of revolutions being changed to the target number of revolutions, the longer is the waiting time for updating the driving voltage that is determined on the basis of the target number of revolutions.
